# EUROPEAN PATENT SPECIFICATION

(11) **EP 2 915 191 B1**
(45) Date of publication and mention of the grant of the patent: **15.04.2020**
(21) Application number: 13795327.9
(22) Date of filing: 30.10.2013
(51) Int. Cl.: H01L 21/60, H01L 23/485

(54) **METHOD OF FABRICATING A CONDUCTIVE INTERCONNECT WITH AN INORGANIC COLLAR**
VERFAHREN ZUR HERSTELLUNG EINES LEITFÄHIGEN VERBINDUNGSELEMENTS MIT EINER ANORGANISCHEN MANSCHETTE
PROCÉDÉ DE FABRICATION D'UNE INTERCONNEXION CONDUCTRICE AVEC UN COLLIER INORGANIQUE

(30) Priority: 02.11.2012 US 201261721889 P; 11.02.2013 US 201313764261
(43) Date of publication of application: 09.09.2015
(73) Proprietor: Qualcomm Incorporated, San Diego, CA 92121 (US)
(72) Inventor: SUN, Yangyang, San Diego, California 92121 (US); ZHAO, Lily, San Diego, California 92121 (US); HAN, Michael, San Diego, California 92121 (US)
(74) Representative: Howe, Steven
(86) International application number: PCT/US2013/067568
(87) International publication number: WO 2014/070926

(56) References cited:
- EP-B1- 1 239 332
- WO-A1-2005/124868
- WO-A1-2012/107971
- JP-A- S 642 339
- JP-A- H10 209 163
- JP-A- 2011 091 087
- US-A1- 2003 052 409
- US-A1- 2007 231 957
- US-A1- 2007 238 222
- US-A1- 2007 290 343
- US-A1- 2011 266 667
- US-A1- 2011 285 011
- US-A1- 2011 298 123
- US-B1- 6 218 281
- "Spin-on dielectrics", , 14 October 2012 (2012-10-14), XP055107885, Retrieved from the Internet: URL:http://web.archive.org/web/20121014003 631/http://www.azem.com/en/Products/Silico n-technology/Spin-on%20Dielectrics.aspx [retrieved on 2014-03-14]

## Description

### Field

The present disclosure generally relates to semiconductor device assembly. More specifically, the present disclosure relates to a method of fabricating a conductive interconnect including an inorganic collar for protecting the conductive interconnect during a seed layer etch and preventing a solder bridge during chip attach.

### Background

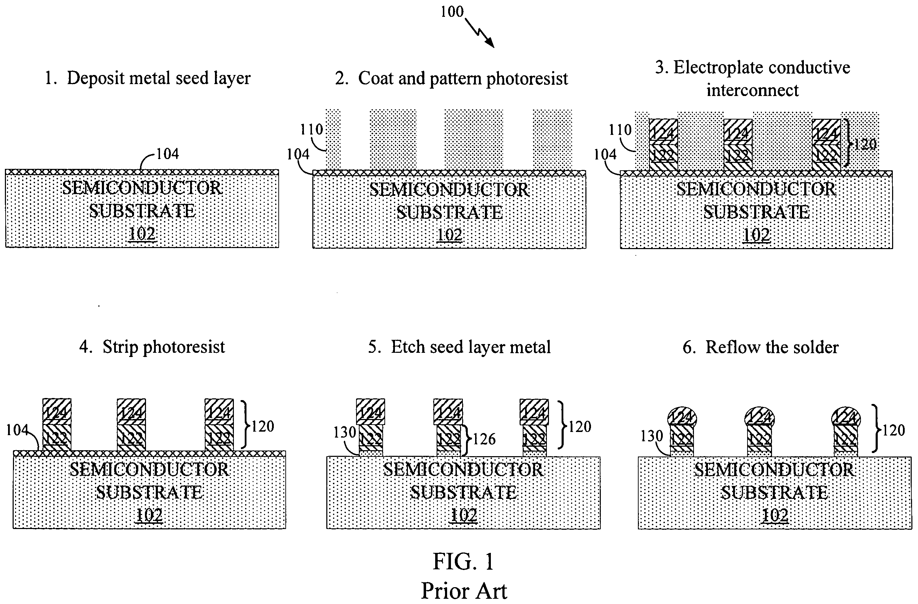

In flip-chip packaging, an active device region of an integrated circuit (IC) (e.g., a die) is on a surface facing a package substrate (e.g., downward). In this arrangement, interconnects (such as pillars) from the IC may electrically couple with contact pads on the package substrate. The pillar can be copper, tin solder or silver solder. A copper pillar may be fabricated according to a plating method, for example, as shown in FIGURE 1.

As shown in FIGURE 1, an electroplating method 100 for fabricating copper pillars 120 includes a first process of depositing a conductive seed layer 104 (e.g., metal) on a semiconductor wafer or die (e.g., a semiconductor substrate) 102. As described herein, the term "semiconductor substrate" may refer to a substrate of a diced wafer or may refer to the substrate of a wafer that is not diced. In a second process, a photoresist material 110 is deposited and patterned on the conductive seed layer 104. Next, an electroplating process forms copper pillars 120. The copper pillars 120 may by formed using an electroplating process to grow a copper layer 122 and a solder layer 124 (e.g. silver (Ag), tin (Sn), Indium (In), or nickel (Ni)). The photoresist 110 is then stripped.

The electroplating method 100 includes a seed layer etch to remove portions of the conductive seed layer 104 between the pillars 120 to form an under bump conductive layer 130. This etch may be a non-isotropic etch that removes the conductive seed layer 104 in all directions. Removal of the conductive seed layer 104 between the pillars 120 prevents shorting of the copper pillars 120 causing faulty interconnect operation. Unfortunately, the etch process also over-etches the copper layer 122 to form an undercut 126. The undercut 126 reduces the contact area of the copper pillars 120 on the semiconductor substrate 102. The reduced contact area may degrade the connectivity as well as the integrity of the copper pillars 120.

In this example, the undercut 126 may be in the range of three (3) micrometers (microns) on each side of the copper pillars 120. The current control limit for the manufacturing site (e.g., the foundry) is less than six micrometers (microns) of undercut on each side of a bump interconnect of the copper pillars 120. The undercut amount is significant when the bump diameter is, for example, less than sixty micrometers (microns). At this size, six micrometers (microns) of over etch may result in a 10% to 20% loss in the copper pillars 120. As a result, fabricating copper pillars 120 for fine pitch/size designs is challenging due to copper over etching. After the etching, a thermal process reflows the solder layer 124 of the copper pillars 120. Consequently, surface tension causes a round shape of the solder layer 124.

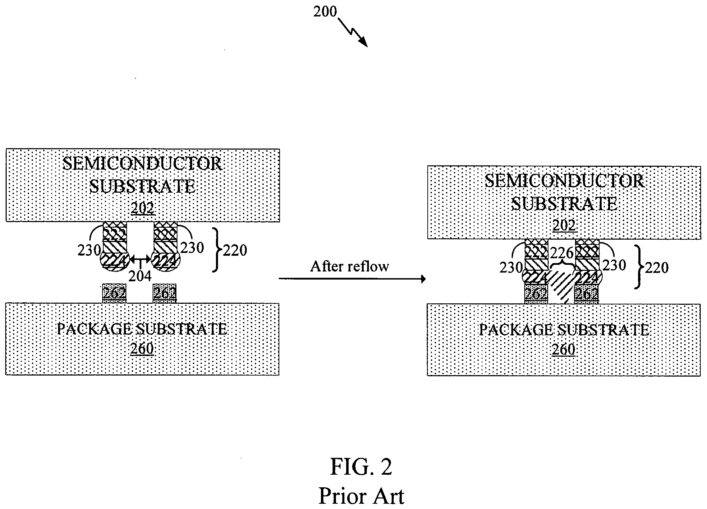

Conventional solutions for preventing the undercut 126 to the copper layer 122 of the copper pillars 120 include changing the etch process to reduce an amount of,the undercut 126. Changing the etch process, however, involves a fundamental process change to develop a new etch mechanism. Another conventional solution is increasing a bump diameter of the copper pillars 120, for example, as shown in FIGURE 2.

FIGURE 2 illustrates a chip attach process 200 for attaching a semiconductor substrate (e.g., an IC die/chip, flip chip) 202 (e.g., an IC device) to a package substrate 260 or another semiconductor substrate. Note that FIGURE 2 shows the semiconductor substrate 202 facing downwardly, whereas the semiconductor substrate 102 of FIGURE 1 is oriented to face upwardly. In this example, a bump diameter of the solder bumps 224 as well as the copper layer 222 of the copper pillars 220 is increased. This increase in the bump diameter, however, is limited by a bump pitch 204. When a clearance (e.g., bump pitch 204) between the solder bumps 224 (or between the solder bumps 224 and traces (not shown)) is reduced by the increased bump diameter, a solder bridge 226 develops after the thermal process to couple the solder bumps 224 of the copper pillars 220 to contact pads 262 of the package substrate 260 during flip chip assembly. That is, flip chip reflow to couple the contact pads 262 and the solder bumps 224 of the copper pillars 220 results in the solder bridge 226 between the solder bumps 224.

US 2011/266667 A1 discloses a method of fabricating a conductive interconnect on a semiconductor substrate comprising: depositing a conductive seed layer on the semiconductor substrate, depositing and patterning a photoresist material on the conductive seed layer, fabricating a conductive material (a conductive pillar) on regions of the conductive seed layer exposed by the patterned photoresist material, stripping the photoresist material, depositing an organic dielectric material on the conductive seed layer and the conductive material, patterning the organic spin on dielectric material to form an organic collar that surrounds the conductive material and etching the conductive seed layer to form a conductive support layer, thereby forming the conductive interconnect comprising the conductive support layer, the conductive material and the organic collar.

JP 2011 091 087 A discloses a method of fabricating a conductive interconnect on a semiconductor substrate comprising: depositing a conductive seed layer on the semiconductor substrate, depositing and patterning a photoresist material on the conductive seed layer, fabricating a conductive material on regions of the conductive seed layer exposed by the patterned photoresist material, stripping the photoresist material, depositing an organic spin on dielectric material on the conductive seed layer and the conductive material, patterning the organic spin on dielectric material to form an organic collar that partially surrounds the conductive material, curing the organic collar by heating and etching the conductive seed layer to form a conductive support layer, thereby forming the conductive interconnect comprising the conductive support layer, the conductive material and the organic collar.

US 2007/231957 A1 discloses a method of fabricating a conductive interconnect on a semiconductor substrate comprising: depositing a conductive seed layer on the semiconductor substrate, depositing and patterning a photoresist material on the conductive seed layer, fabricating a conductive material on regions of the conductive seed layer exposed by the patterned photoresist material, stripping the photoresist material, depositing an inorganic dielectric material on the conductive seed layer and the conductive material by a CVD method, patterning the inorganic dielectric material to form an inorganic collar that surrounds the conductive material and etching the conductive seed layer to form a conductive support layer, thereby forming the conductive interconnect comprising the conductive support layer, the conductive material and the inorganic collar.

JP S64 2339 A discloses a method in which an organic insulating film having an aperture is provided on an intermediate metal layer on an electrode pad and a metal-plated layer is provided in the aperture of the organic insulating film to form a bump, followed by etching the intermediate metal layer and softening the organic insulating film to cover the sidewalls of the etched intermediate metal layer.

EP 1 239 332 B1 discloses a silazane precursor material which is transformed to inorganic SiO₂ by heating. See also "Spin-on dielectrics" http://web.archive.org/web/20121014003631/http://www.azem.com/en/Products/Silicon -technology/Spin-on%20Dielectrics.aspx.

### SUMMARY

The invention is defined in the appended independent claim. Optional features are defined in the dependent claims. Additional features and advantages of the disclosure will be described below. It should be appreciated by those skilled in the art that this disclosure may be readily utilized as a basis for modifying or designing other structures for carrying out the same purposes of the present disclosure. The novel features, which are believed to be characteristic of the disclosure, both as to its organization and method of operation, together with further objects and advantages, will be better understood from the following description when considered in connection with the accompanying figures. It is to be expressly understood, however, that each of the figures is provided for the purpose of illustration and description only and is not intended as a definition of the limits of the present disclosure.

### BRIEF DESCRIPTION OF THE DRAWINGS

The features, nature, and advantages of the present disclosure will become more apparent from the detailed description set forth below when taken in conjunction with the drawings in which like reference characters identify correspondingly throughout.
FIGURE 1 is a block diagram illustrating a conventional plating method for fabricating a copper pillar.
FIGURE 2 is a block diagram illustrating a conventional assembly process for attaching a flip chip to a package substrate in which a solder bridge is formed.
FIGURE 3 is a block diagram illustrating a plating method for fabricating a conductive interconnect including an inorganic collar according to one aspect of the present disclosure, and further illustrates an example of a conductive interconnect including an inorganic collar.
FIGURE 4 is a block diagram illustrating an assembly process for attaching a flip chip to a package substrate using conductive interconnects according to one aspect of the present disclosure, and further illustrates an example of a flip chip package including conductive interconnects having inorganic collars.
FIGURE 5 is a block diagram illustrating a plating method for fabricating a conductive interconnect including an inorganic collar according to another aspect of the present disclosure, and further illustrates an example of a conductive interconnect including a single conductive material surrounded by an inorganic collar.
FIGURE 6 is a block diagram illustrating an assembly process for attaching a flip chip to a package substrate using conductive interconnects according to another aspect of the present disclosure, and further illustrates an example of a flip chip package including conductive interconnects having inorganic collars.
FIGURE 7 is a block diagram illustrating a method for fabricating a conductive interconnect including an inorganic collar according to one aspect of the present disclosure.
FIGURE 8 is a block diagram showing an exemplary wireless communication system in which a conductive interconnect including an inorganic collar of the disclosure may be advantageously employed.

### DETAILED DESCRIPTION

The detailed description set forth below, in connection with the appended drawings, is intended as a description of various configurations and is not intended to represent the only configurations in which the concepts described herein may be practiced. The detailed description includes specific details for the purpose of providing a thorough understanding of the various concepts. However, it will be apparent to those skilled in the art that these concepts may be practiced without these specific details. In some instances, well-known structures and components are shown in block diagram form in order to avoid obscuring such concepts. As described herein, the use of the term "and/or" is intended to represent an "inclusive OR", and the use of the term "or" is intended to represent an "exclusive OR".

Aspects of the present application provide solutions for improved assembly of integrated circuit (IC) devices (e.g., flip chip devices or micro-electromechanical systems (MEMS) devices). For example, as shown in FIGURES 1 and 2, a non-isotropic etch for removing a conductive seed layer 104 is performed to prevent shorting between the copper pillars 120. Unfortunately, the etch process also over etches a copper layer 122 of a pillar 120 and a conductive seed layer 104 to form an undercut 126. Furthermore, the undercut 126 reduces the contact area of the copper pillars 120 on the semiconductor substrate 102. The reduced contact area may degrade the connectivity as well as the integrity of the copper pillars 120.

Conventional solutions for preventing the undercut 126 to the copper layer 122 include changing the etch process to reduce an amount of the undercut 126. Changing the etch process, however, involves a fundamental process change to develop a new etch mechanism. Another conventional solution is increasing a bump diameter of the copper pillars, for example, as shown in FIGURE 2. Increasing the bump diameter, however, is limited by a bump pitch 204. When the clearance (e.g., the bump pitch 204) between solder bumps 224 is reduced by the increased bump diameter, a solder bridge 226 develops after the thermal process to couple the solder bumps 224 of the copper pillars 220 to contact pads 262 of the package substrate 260 during flip chip assembly.

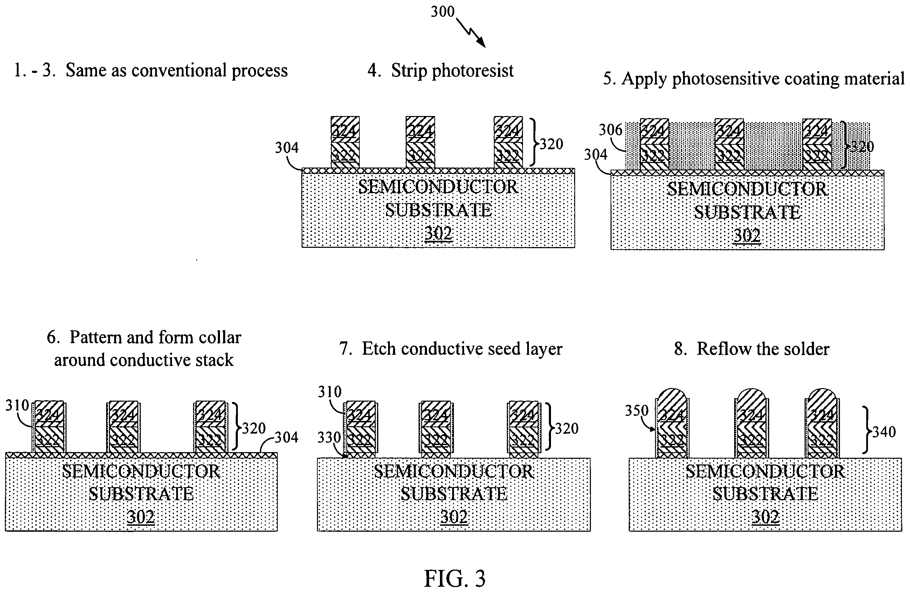

One aspect of the disclosure provides an inorganic collar for protecting a conductive interconnect during a seed layer etch. The inorganic collar also prevents a solder bridge from forming during chip attach. FIGURE 3 is a block diagram illustrating a plating method 300 for fabricating conductive interconnects 340 including an inorganic collar 350, according to one aspect of the present disclosure.

As shown in FIGURE 3, the conventional process of FIGURE 1 may be used to form conductive material stacks 320 on a conductive seed layer 304 deposited on a semiconductor substrate (wafer or die) 302. In one configuration, the conductive material stacks 320 are used to form conductive interconnects following stripping of the photoresist. The conductive material stacks 320 may be formed using an electroplating process to grow a first conductive layer 322 and a second conductive layer 324, for example, arranged as a conductive pillar. The first conductive layer 322 may include, but is not limited to, copper (Cu), nickel (Ni), gold (Au), or other like plated metal that will not melt during thermal treatment (e.g., reflow). The second conductive layer 324 may include, but is not limited to, indium (In), bismuth (Bi), and lead (Pb), or other like plated metal or alloy that will melt during thermal treatment (e.g., reflow).

In another aspect of the disclosure, a barrier layer (not shown) may be deposited between the first conductive layer 322 and the second conductive layer 324. A thickness of the first conductive layer 322 may be in the range of a few to hundreds of microns. A thickness of the second conductive layer 324 may be in the range of a few to hundreds of microns. Next, an organic spin on dielectric material 306 may be applied on the conductive seed layer 304 and the conductive material stacks 320. In one configuration, the organic spin on dielectric material 306 is a photosensitive spin on dielectric material that transitions from an organic material to an inorganic material following a thermal process. An example material is a photosensitive spin on dielectric (PSOD) from AZ Electronic Materials.

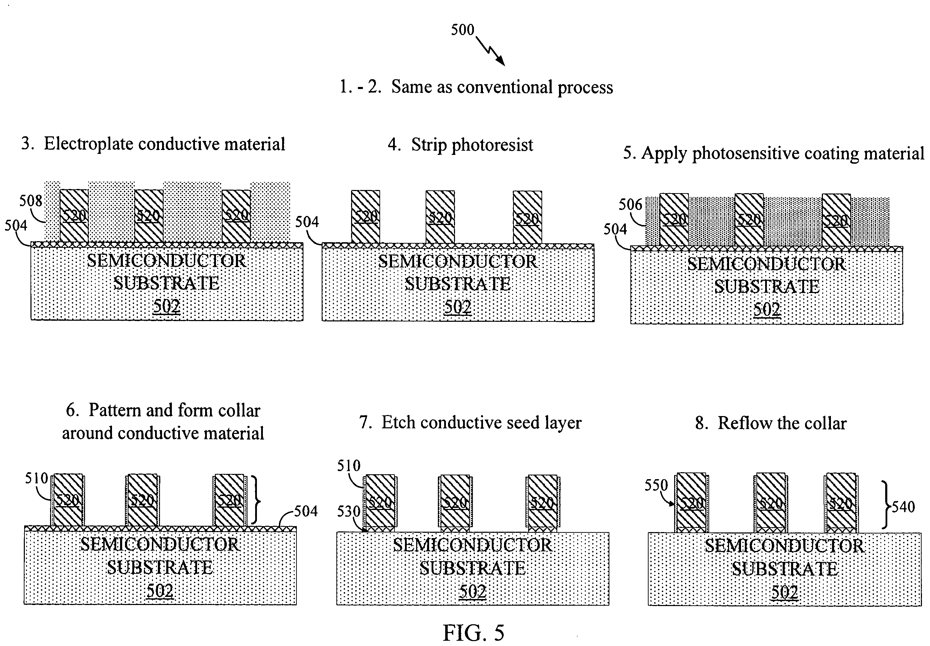

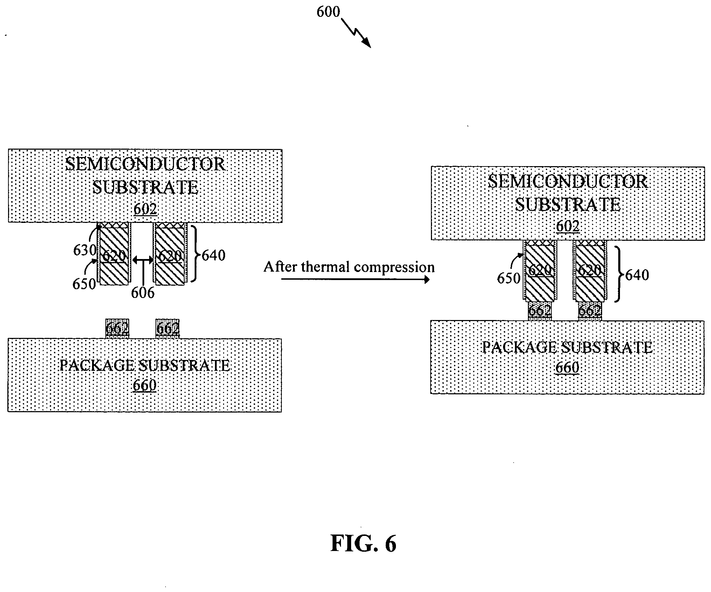

As further shown in FIGURE 3, the organic spin on dielectric material 306 is patterned using, for example, a photolithographic process to form an organic collar 310. A thickness of the organic collar 310 may be in the range of a few hundred nanometers to a few micrometers (microns). Next, the conductive seed layer 304 is etched to form a conductive support layer 330. This process may be performed using a non-isotropic etch that removes the conductive seed layer 304 in all directions because excessive remaining portions of the conductive seed layer 304 may cause faulty interconnect operation. In this embodiment, the organic collar 310, however, protects the first conductive layer 322 of the conductive material stacks 320 and the conductive support layer 330 from the over etching shown in FIGURE 1. Finally, a thermal process is performed to reflow the second conductive layer 324 of the conductive material stacks 320 to form conductive interconnects 340. Surface tension causes the round shape of the second conductive layer 324. An alternative embodiment is shown in FIGURES 5 and 6, in which a single conductive material 520/620 replaces the conductive material stacks 320.

The thermal process causes a transition of the spin on dielectric material 306 of the organic collar 310 from an organic material to an inorganic material that may be similar in composition to, for example, silicon dioxide (SiO₂). The inorganic material forms an inorganic collar 350 that partially surrounds the conductive interconnects 340. In one aspect of the disclosure, the inorganic collar 350 is composed of a curable inorganic material, including silicon, that exhibits a thermal cross link reaction during the thermal process. As a result, the thermal process for forming the inorganic collar 350 causes the spin on dielectric material 306 to flow onto the sidewalls of the conductive support layer 330 prior to curing into the inorganic collar 350.

In one aspect of the disclosure, a thermal crosslink reaction during the thermal treatment causes the spin on dielectric material 306 of the organic collar 310 to flow onto the conductive seed layer 304. In this aspect of the disclosure, a thermal cross link reaction is a chemical reaction that joins the smaller molecules of the spin on dielectric material 306 into a large network that forms a cured, solid matter of the inorganic collar 350. That is, the thermal treatment causes the spin on dielectric material 306 to flow onto the sidewalls of the conductive support layer 330

Moreover, the inorganic collar 350 has good thermal conductivity. The semiconductor substrate 302, including the conductive interconnects 340, may be assembled into an integrated circuit (IC) device package. In this configuration, the inorganic collar 350 provides an improved heat dissipation path when compared to the other organic materials around the conductive interconnects 340, such as underfill and/or molding compound of the assembled package. Thus, heat is easily dissipated through the inorganic collar 350 of the conductive interconnects 340. In addition, the inorganic collar 350 can withstand high temperatures.

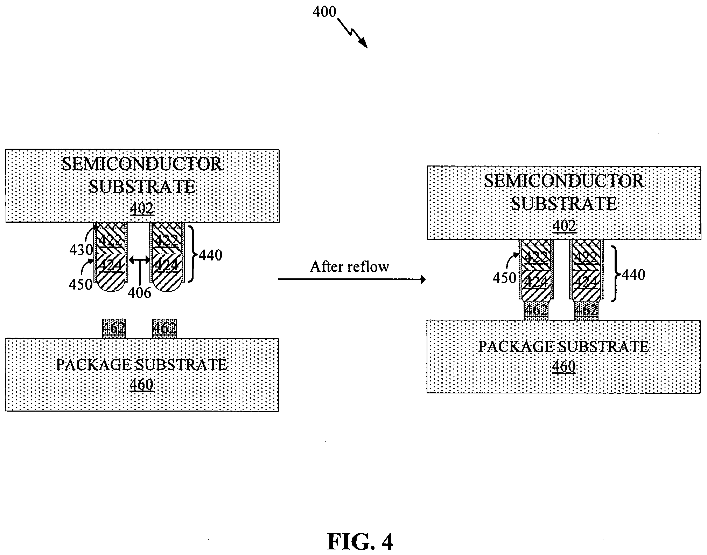

FIGURE 4 is a block diagram illustrating an assembly process 400 for attaching a semiconductor substrate (e.g., an IC device, such as a flip chip device or a MEMS device) 402 to a package substrate 460 using conductive interconnects 440 according to one aspect of the present disclosure. In this configuration, the semiconductor substrate 402 includes conductive interconnects 440 formed by the process shown in FIGURE 3 and separated by a distance (e.g., an interconnect pitch 406). Representatively, the conductive interconnects 440 include a conductive material stack of a first conductive layer 422 and a second conductive layer 424 formed on a conductive support layer 430 and surrounded by an inorganic collar 450. Following reflow, the second conductive layer 424 of the conductive interconnects 440 couples to contact pads 462 of the package substrate 460.

In this aspect of the disclosure, the use of the inorganic collar 450 protects the composition of the first conductive layer 422 of the conductive interconnects 440 during the seed layer etch to eliminate or reduce any undercutting to the first conductive layer 422. Protecting the composition of the first conductive layer 422 may increase an extremely low-K (ELK) robustness and improve a interconnect fatigue life of the conductive interconnects 440. In addition, the inorganic collar 450 prevents the solder bridge problem shown in FIGURE 2. Eliminating the solder bridge problem enables a further reduction of the interconnect pitch 406 to support fine pitch/size designs for devices such as micro-electromechanical systems (MEMS) devices as well as flip chip devices. Furthermore, eliminating undercutting maintains a diameter of the first conductive layer 422 of the conductive interconnects 440 to provide an increased contact area of the conductive interconnects 440 to the semiconductor substrate 402. The increased contact area may improve the connectivity as well as the integrity of the conductive interconnects 440.

FIGURE 5 is a block diagram illustrating a plating method 500 for fabricating a conductive interconnect 540 including an inorganic collar 550 according to another aspect of the present disclosure. An example of a conductive interconnect 540 is supported by a semiconductor substrate 502. The conductive interconnect 540 includes an inorganic collar 550 that surrounds a single conductive material 520 and sidewalls of a conductive support layer 530.

As shown in FIGURE 5, the conventional process of FIGURE 1 may be used to form a photoresist pattern 508. In step 3, a single conductive material 520 is electroplated within the photoresist pattern 508 and on a conductive seed layer 504 deposited on a semiconductor substrate (wafer or die) 502. In step 4, the photoresist pattern 508 is stripped to expose the single conductive material 520 and the conductive seed layer 504. Steps 5 to 7 are similar to steps 5 to 7 in FIGURE 3, however, the single conductive material 520 is provided in place of the conductive material stacks 320. As shown in step 8, the conductive interconnects 540 include the single conductive material 520, which does not reflow during the thermal process to form the inorganic collar 550. A thermal process causes the spin on dielectric material 506 to flow onto sidewalls of the conductive support layer 530 prior to curing into the inorganic collar 550 to complete formation of the conductive interconnects 540, as shown in step 8.

FIGURE 6 is a block diagram illustrating an assembly process 600 for attaching a semiconductor substrate (e.g., an IC device, such as a flip chip device or a MEMS device) 602 to a package substrate 660 using conductive interconnects 640 according to one aspect of the present disclosure. In this configuration, the semiconductor substrate 602 includes conductive interconnects 640 formed by the process shown in FIGURE 5 and separated by a distance (e.g., an interconnect pitch 606). Representatively, the conductive interconnects 640 include a single conductive material 620 formed on a conductive support layer 630 and surrounded by an inorganic collar 650. In this configuration, the single conductive material 620 of the conductive interconnects 640 can be directly bonded to the conductive pads 662 using thermal compression bonding or other like processes for applying a sufficient amount of heat and pressure to couple with the conductive pads 662. Following the thermal compression bonding, the single conductive material 620 of the conductive interconnects 640 couples to the conductive pads 662 to join the semiconductor substrate 602 to the package substrate 660.

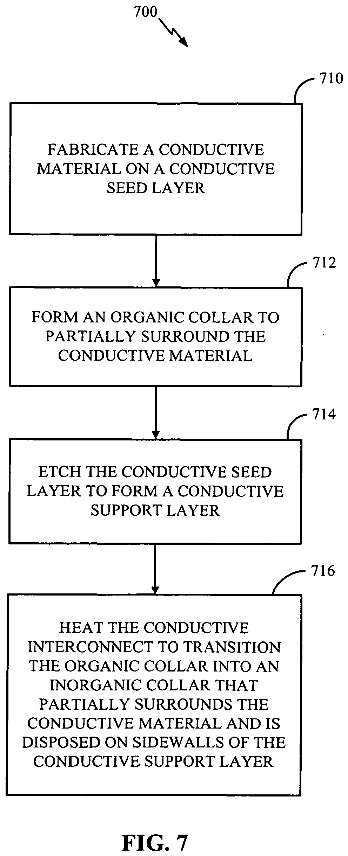

FIGURE 7 is a block diagram illustrating a method 700 for fabricating a conductive interconnect including an inorganic collar according to one aspect of the present disclosure. In block 710, a conductive material is fabricated on a conductive seed layer. For example, as shown in FIGURE 3, conductive material stacks 320 are formed on a conductive seed layer 304 deposited on a semiconductor substrate 302. In one configuration, the conductive material stacks 320 are used to form conductive interconnects following stripping of a photoresist. The conductive material stacks 320 may by formed using an electroplating process to grow a first conductive layer 322 (e.g., copper (Cu), nickel (Ni), gold (Au)) and a second conductive layer 324 (e.g., indium (In), bismuth (Bi), and lead (Pb)). Alternatively, a single conductive material 520 is fabricated on a conductive seed layer 504 deposited on a semiconductor substrate 502, as shown in FIGURE 5.

In block 712, an organic collar is formed to partially surround the conductive material. For example, as shown in FIGURE 3, an organic spin on dielectric material 306 may be applied on the conductive seed layer 304 and the conductive material stacks 320. The organic spin on dielectric material 306 is patterned using, for example, a photolithographic process to form the organic collar 310. Alternatively, an organic spin on dielectric material 506 is applied on a conductive seed layer 504 and the single conductive material 520. A photolithographic process forms the organic collar 510 around the single conductive material 520, as shown in FIGURE 5. At block 714, the conductive seed layer is etched to form a conductive support layer. For example, as shown in FIGURE 3, the conductive seed layer 304 is etched to form a conductive support layer 330. As shown in FIGURE 5, the conductive seed layer 504 is etched to form a conductive support layer 530.

Referring again to FIGURE 7, in block 716, the conductive interconnect is subjected to a thermal process (i.e., heated) to transition the organic collar into an inorganic collar that partially surrounds the conductive material. The inorganic collar is disposed on sidewalls of a conductive support layer. In the configuration shown in FIGURE 3, the inorganic collar 350 is composed of a curable inorganic material that exhibits a thermal cross link reaction during the thermal process. As a result, the thermal process for forming the inorganic collar 350 causes the spin on dielectric material 306 to flow onto sidewalls of the conductive support layer 330 prior to curing into the inorganic collar 350.

Accordingly, the method 700 of FIGURE 7 may be carried out by the structures and components described above in relation to FIGURES 3 and 4. Alternatively, as shown in FIGURE 6, a spin on dielectric material 506 is applied to the conductive seed layer 504 and a single conductive material 520. The organic spin on dielectric material 506 is patterned using, for example, a photolithographic process to form the organic collar 510. The conductive seed layer 504 is then etched to form a conductive support layer 530. A thermal process causes the spin on dielectric material 506 to flow onto sidewalls of the conductive support layer 530 prior to curing into the inorganic collar 550, as shown in FIGURE 5. This alternative method may be carried out by the structures and components described in relation to FIGURES 5 and 6.

As noted, etch loss to a conductive material during a seed layer etch process is a concern for the conductive material(s) during the conductive interconnect formation process, for example, as shown in FIGURES 3 to 7. The method 700 may protect the first conductive material 522 of the conductive material stacks 320 or a single conductive material 520 during the seed layer etch process. After the plating photoresist is stripped, an organic spin on dielectric material 306/506 (e.g., a photosensitive spin on dielectric material) is coated on the conductive material stacks 320 or the single conductive material 520. This dielectric material 306/506 is patterned using a photolithographic process to form an organic material having a collar structure (e.g., the organic collar 310/510) around the conductive material stacks 320 or the single conductive material 520. During seed etch, the organic collar 310/510 can protect the conductive material stacks 320 or the single conductive material 520 from over etching. As shown in FIGURE 3, a thermal process reflows the second conductive layer 324 of the conductive material stacks 320 to form the conductive interconnects 340 including the inorganic collar 350. As shown in FIGURE 5, the conductive interconnects 540 include the single conductive material 520, which does not reflow during the thermal process to form the inorganic collar 550.

In this aspect of the disclosure, a thermal process causes a transition of the spin on dielectric material 306/506 from an organic material to an inorganic material, such as silicon dioxide (SiO₂). In addition, the thermal process causes the spin on dielectric material 306/506 to flow onto the sidewalls of the conductive support layer 330/530 to form the inorganic collar 350/550. The inorganic collar 350 around the conductive material stacks 320 also prevents the solder bridge problem during semiconductor chip assembly. Eliminating the solder bridge problem enables a further reduction of the interconnect pitch to support fine pitch/size designs for semiconductor devices. Furthermore, eliminating undercutting maintains a diameter of the first conductive layer 422 or the single conductive material 520 of the conductive interconnects 440/540. This configuration provides an increased contact area of the conductive interconnects 440/540 to the semiconductor substrate 402/502. The increased contact areas also improve the connectivity as well as the integrity of the conductive interconnects 440/540.

In one configuration, a conductive interconnect includes a conductive material on a conductive support layer. The conductive interconnect also includes means for protecting the conductive material and the conductive support layer of the conductive interconnect. The protecting means may partially surround the conductive material and is disposed on sidewalls of the conductive support layer. In one aspect, the protecting means may be the inorganic collar 350/450/550/650 configured to perform the functions recited by the protecting means. In another aspect, the aforementioned means may be any component or any structure configured to perform the functions recited by the aforementioned means.

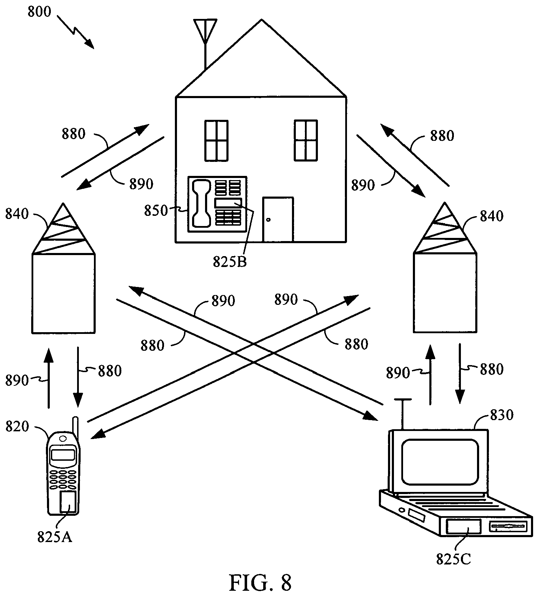

FIGURE 8 shows an exemplary wireless communication system 800 in which a configuration of the disclosed conductive interconnect including the inorganic collar may be advantageously employed. For purposes of illustration, FIGURE 8 shows three remote units 820, 830, and 850 and two base stations 840. It will be recognized that wireless communication systems may have many more remote units and base stations. Remote units 820, 830, and 850 include conductive interconnects 825A, 825B, and 825C, respectively. FIGURE 8 shows forward link signals 880 from the base stations 840 and the remote units 820, 830, and 850 and reverse link signals 890 from the remote units 820, 830, and 850 to base stations 840.

In FIGURE 8, the remote unit 820 is shown as a mobile telephone, remote unit 830 is shown as a portable computer, and remote unit 850 is shown as a fixed location remote unit in a wireless local loop system. For example, the remote units may be cell phones, hand-held personal communication systems (PCS) units, a set top box, a music player, a video player, an entertainment unit, a navigation device, portable data units, such as personal data assistants, or fixed location data units such as meter reading equipment. Although FIGURE 8 illustrates remote units, which may employ conductive interconnects according to the teachings of the disclosure, the disclosure is not limited to these exemplary illustrated units. For instance, the conductive interconnects according to configurations of the present disclosure may be suitably employed in any device.

Although specific circuitry has been set forth, it will be appreciated by those skilled in the art that not all of the disclosed circuitry is required to practice the disclosed configurations. Moreover, certain well known circuits have not been described, to maintain focus on the disclosure. Similarly, although the relative terms "upper" and "lower" are used, these terms are non-limiting. For example if a device is rotated by 90 degrees the terms "upper" and "lower" would refer to "left most" and "right most" portions.

Those of skill would further appreciate that the various illustrative logical blocks, modules, circuits, and algorithm steps described in connection with the disclosure herein may be implemented as electronic hardware, computer software, or combinations of both. To clearly illustrate this interchangeability of hardware and software, various illustrative components, blocks, modules, circuits, and steps have been described above generally in terms of their functionality. Whether such functionality is implemented as hardware or software depends upon the particular application and design constraints imposed on the overall system. Skilled artisans may implement the described functionality in varying ways for each particular application, but such implementation decisions should not be interpreted as causing a departure from the scope of the present disclosure.

The steps of a method or algorithm described in connection with the disclosure herein may be embodied directly in hardware, in a software module executed by a processor, or in a combination of the two.

The methodologies described herein may be implemented by various components depending upon the application. For example, these methodologies may be implemented in hardware, firmware, software, or any combination thereof For a hardware implementation, the processing units may be implemented within one or more application specific integrated circuits (ASICs), digital signal processors (DSPs), digital signal processing devices (DSPDs), programmable logic devices (PLDs), field programmable gate arrays (FPGAs), processors, controllers, micro-controllers, microprocessors, electronic devices, other electronic units designed to perform the functions described herein, or a combination thereof.

For a firmware and/or software implementation, the methodologies may be implemented with modules (e.g., procedures, functions, and so on) that perform the functions described herein. Any machine-readable medium tangibly embodying instructions may be used in implementing the methodologies described herein. For example, software codes may be stored in a memory and executed by a processor unit. Memory may be implemented within the processor unit or external to the processor unit. As used herein the term "memory" refers to any type of long term, short term, volatile, nonvolatile, or other memory and is not to be limited to any particular type of memory or number of memories, or type of media upon which memory is stored.

If implemented in firmware and/or software, the functions may be stored as one or more instructions or code on a computer-readable medium. Examples include computer-readable media encoded with a data structure and computer-readable media encoded with a computer program. Computer-readable media includes physical computer storage media. A storage medium may be any available medium that can be accessed by a computer. By way of example, and not limitation, such computer-readable media can comprise RAM, ROM, EEPROM, CD-ROM or other optical disk storage, magnetic disk storage or other magnetic storage devices, or any other medium that can be used to store desired program code in the form of instructions or data structures and that can be accessed by a computer; disk and disc, as used herein, includes compact disc (CD), laser disc, optical disc, digital versatile disc (DVD), floppy disk and blu-ray disc where disks usually reproduce data magnetically, while discs reproduce data optically with lasers. Combinations of the above should also be included within the scope of computer-readable media.

In addition to storage on computer readable medium, instructions and/or data may be provided as signals on transmission media included in a communication apparatus. For example, a communication apparatus may include a transceiver having signals indicative of instructions and data. The instructions and data are configured to cause one or more processors to implement the functions outlined in the claims.

Although the present disclosure and its advantages have been described in detail, it should be understood that various changes, substitutions and alterations can be made herein without departing from the technology of the disclosure as defined by the appended claims. For example, relational terms, such as "above" and "below" are used with respect to a substrate or electronic device. Of course, if the substrate or electronic device is inverted, above becomes below, and vice versa. Additionally, if oriented sideways, above and below may refer to sides of a substrate or electronic device. Moreover, the scope of the present application is not intended to be limited to the particular embodiments of the process, machine, manufacture, composition of matter, means, methods and steps described in the specification. As one of ordinary skill in the art will readily appreciate from the disclosure, processes, machines, manufacture, compositions of matter, means, methods, or steps, presently existing or later to be developed that perform substantially the same function or achieve substantially the same result as the corresponding embodiments described herein may be utilized according to the present disclosure. Accordingly, the appended claims are intended to include within their scope such processes, machines, manufacture, compositions of matter, means, methods, or steps.

## Claims

1. A method of fabricating a conductive interconnect (340, 540) on a semiconductor substrate (302, 502), comprising:
depositing a conductive seed layer (304, 504) on the semiconductor substrate (302, 502);
depositing and patterning a photoresist material (508) on the conductive seed layer (304, 504);
fabricating a conductive material (320, 520) on regions of the conductive seed layer (304, 504) exposed by the patterned photoresist material (508);
stripping the photoresist material (508);
depositing an organic spin on dielectric material (306, 506) on the conductive seed layer (304, 504) and the conductive material (320, 520);
patterning the organic spin on dielectric material (306, 506) to form an organic collar (310, 510) that partially surrounds the conductive material (320, 520); and
etching the conductive seed layer (304, 504) to form a conductive support layer (330, 530);
the method further comprising performing a thermal process by heating, the thermal process causing the organic spin on dielectric material of the organic collar (310, 510) to flow onto sidewalls of the conductive support layer (330, 530), the thermal process then curing the organic spin on dielectric material to transition the organic collar (310, 510) into an inorganic collar (350, 550) that partially surrounds the conductive material (320, 520) and is disposed on the sidewalls of the conductive support layer (330, 530), thereby forming the conductive interconnect (340, 540) comprising the conductive support layer (330, 530), the conductive material (320, 520) on the conductive support layer (330, 530) and the inorganic collar (350, 550).

2. The method of claim 1, wherein the fabricating the conductive material (320) comprises:
depositing a first conductive layer (322) on the conductive seed layer (304); depositing a second conductive layer (324) on the first conductive layer (322); and
depositing a barrier layer between the first conductive layer (322) and the second conductive layer (324) to form a conductive material stack, further comprising reflowing, during the thermal process, the second conductive layer (324) of the conductive material stack.

3. The method of claim 1, further comprising integrating the conductive interconnect into a mobile phone, a set top box, a music player, a video player, an entertainment unit, a navigation device, a computer, a hand-held personal communication systems (PCS) unit, a portable data unit, and/or a fixed location data unit.

## Patentansprüche

1. Verfahren zur Herstellung einer leitfähigen Verbindung (340, 540) auf einem Halbleitersubstrat (302, 502), das Folgendes beinhaltet:
Absetzen einer leitfähigen Seed-Schicht (304, 504) auf dem Halbleitersubstrat (302, 502);
Absetzen und Strukturieren eines Fotoresistmaterials (508) auf der leitfähigen Seed-Schicht (304, 504);
Herstellen eines leitfähigen Materials (320, 520) auf Regionen der leitfähigen Seed-Schicht (304, 504), die durch das strukturierte Fotoresistmaterial (508) exponiert wird;
Abziehen des Fotoresistmaterials (508);
Absetzen eines organischen Spins auf dielektrischem Material (306, 506) auf der leitfähigen Seed-Schicht (304, 504) und dem leitfähigen Material (320, 520);
Strukturieren des organischen Spins auf dielektrischem Material (306, 506) zum Bilden einer organischen Manschette (301, 510), die das leitfähige Material (320, 520) teilweise umgibt; und
Ätzen der leitfähigen Seed-Schicht (304, 504) zum Bilden einer leitfähigen Trägerschicht (330, 530);
wobei das Verfahren ferner das Durchführen eines thermischen Prozesses durch Erhitzen beinhaltet, wobei der thermische Prozess bewirkt, dass der organische Spin auf dielektrischem Material der organischen Manschette (310, 510) auf Seitenwände der leitfähigen Trägerschicht (330, 530) fließt, wobei der thermische Prozess dann den organischen Spin auf dielektrischem Material härtet, um zu bewirken, dass die organische Manschette (310, 510) in eine anorganische Manschette (350, 550) übergeht, die das leitfähige Material (320, 520) teilweise umgibt und an den Seitenwänden der leitfähigen Trägerschicht (330, 530) angeodnet ist, um dadurch die leitfähige Verbindung (340, 540) zu bilden, die die leitfähige Trägerschicht (330, 530), das leitfähige Material (320, 520) und die leitfähige Trägerschicht (330, 530) und die anorganische Manschette (350, 550) umfasst.

2. Verfahren nach Anspruch 1, wobei das Herstellen des leitfähigen Materials (320) Folgendes beinhaltet:
Absetzen einer ersten leitfähigen Schicht (322) auf der leitfähigen Seed-Schicht (304);
Absetzen einer zweiten leitfähigen Schicht (324) auf der ersten leitfähigen Schicht (322); und
Absetzen einer Sperrschicht zwischen der ersten leitfähigen Schicht (322) und der zweiten leitfähigen Schicht (324), um einen leitfähigen Materialstapel zu bilden,
das ferner das Aufschmelzen, während des thermischen Prozesses, der zweiten leitfähigen Schicht (324) des leitfähigen Materialstapels beinhaltet.

3. Verfahren nach Anspruch 1, das ferner das Integrieren der leitfähigen Verbindung zu einem Mobiltelefon, einer Set-Top-Box, einem Musik-Player, einem Video-Player, einer Unterhaltungseinheit, einem Navigationsgerät, einem Computer, einer handgehaltenen PCS-(Personal Communication System)-Einheit, einer tragbaren Dateneinheit und/oder einer fest installierten Dateneinheit beinhaltet.

## Revendications

1. Procédé de fabrication d'une interconnexion conductrice (340, 540) sur un substrat semi-conducteur (302, 502), comprenant :
le dépôt d'une couche d'amorce conductrice (304, 504) sur le substrat semi-conducteur (302, 502) ;
le dépôt et le façonnage d'un matériau de photorésist (508) sur la couche d'amorce conductrice (304, 504) ;
la fabrication d'un matériau conducteur (320, 520) sur des régions de la couche d'amorce conductrice (304, 504) exposées par le matériau de photorésist (508) façonné ;
l'élimination du matériau de photorésist (508) ;
le dépôt d'un spin organique sur matériau diélectrique (306, 506) sur la couche d'amorce conductrice (304, 504) et le matériau conducteur (320, 520) ;
le façonnage du spin organique sur matériau diélectrique (306, 506) pour former un collier organique (310, 510) qui entoure partiellement le matériau conducteur (320, 520) ; et
la gravure de la couche d'amorce conductrice (304, 504) pour former une couche support conductrice (330, 530) ;
le procédé comprenant en outre
l'exécution d'un processus thermique par chauffage, le processus thermique amenant le spin organique sur matériau diélectrique du collier organique (310, 510) à s'écouler sur des parois latérales de la couche support conductrice (330, 530), le processus thermique durcissant ensuite le spin organique sur matériau diélectrique pour transformer le collier organique (310, 510) en un collier inorganique (350, 550) qui entoure partiellement le matériau conducteur (320, 520) et est disposé sur les parois latérales de la couche support conductrice (330, 530), formant ainsi l'interconnexion conductrice (340, 540) comprenant la couche support conductrice (330, 530), le matériau conducteur (320, 520) sur la couche support conductrice (330, 530) et le collier inorganique (350, 550).

2. Procédé selon la revendication 1, dans lequel la fabrication du matériau conducteur (320) comprend :
le dépôt d'une première couche conductrice (322) sur la couche d'amorce conductrice (304) ;
le dépôt d'une seconde couche conductrice (324) sur la première couche conductrice (322) ; et
le dépôt d'une couche barrière entre la première couche conductrice (322) et la seconde couche conductrice (324) pour former un empilement de matériau conducteur,
comprenant en outre la refusion, durant le processus thermique, de la seconde couche conductrice (324) de l'empilement de matériau conducteur.

3. Procédé selon la revendication 1, comprenant en outre l'intégration de l'interconnexion conductrice dans un téléphone portable, un décodeur, un lecteur de musique, un lecteur vidéo, une unité de divertissement, un dispositif de navigation, un ordinateur, une unité de système de communications personnelles (PCS) portable, une unité de données portable, et/ou une unité de données à emplacement fixe.
